**Europäisches Patentamt**

**European Patent Office**

**Office européen des brevets**

(19)

(11) Veröffentlichungsnummer : **0 072 422**
**B1**

(12) **EUROPÄISCHE PATENTSCHRIFT**

(45) Veröffentlichungstag der Patentschrift :
**15.05.85**

(21) Anmeldenummer : **82106015.9**

(22) Anmeldetag : **06.07.82**

(51) Int. Cl.⁴ : **G 01 R 15/02**

(54) **Magnetkern aus weichmagnetischem Material für einen Stromsensor mit einem magnetfeldabhängigen Halbleiterelement zur Erfassung von Gleich- und Wechselströmen.**

(30) Priorität : **31.07.81 DE 3130277**

(43) Veröffentlichungstag der Anmeldung :
**23.02.83 Patentblatt 83/08**

(45) Bekanntmachung des Hinweises auf die Patenterteilung : **15.05.85 Patentblatt 85/20**

(84) Benannte Vertragsstaaten :
**BE CH DE FR LI**

(56) Entgegenhaltungen :
**EP-A- 0 044 592**
**US-A- 3 219 930**
**US-A- 3 573 616**
**LANDIS & GYR MITTEILUNGEN, Band 20, 1973, Seiten 11-13**

(73) Patentinhaber : **VACUUMSCHMELZE GMBH**
**Grüner Weg 37**
**D-6450 Hanau 1 (DE)**

(72) Erfinder : **Hinz, Gerhard, Dipl.-Phys.**
**Siedlungsstrasse 33**
**D-8755 Alzenau (DE)**
Erfinder : **Nillus, Hans-Joachim**
**Leipziger Strasse 29**
**D-6453 Seligenstadt (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft einen Magnetkern aus weichmagnetischem Material für einen Stromsensor, der einen elektrischen Leiter umgibt und in dem ein Einschnitt mit einem darin angeordneten magnetfeldabhängigen Halbleiterelement vorgesehen ist.

Ein magnetfeldabhängiges Halbleiterelement kann beispielsweise ein magnetfeldabhängiger Widerstand (Feldplatte) sein oder es kann auch ein Hallsensor vorgesehen sein, wie er beispielsweise in der Zeitschrift « Feinwerktechnik und Meßtechnik » 88 (1980), Heft 6, Seiten 304 bis 306, beschrieben ist. Mit einem derartigen Hallsensor erhält man eine Spannung, die porportional zu der magnetischen Induktion am Ort des Hallsensors ist.

Aus der US-PS 3 219 930 ist ein an ein Kabel anklemmbarer Stromsensor bekannt, dessen wesentlicher Teil aus zwei Halbschalen aus weichmagnetischem Ferrit besteht. In einem Einschnitt dieser Halbschalen ist ein Hallgenerator angeordnet, so daß der in einem von den Halbschalen umschlossenen Kabel fließende Strom über den auf den Hallgenerator einwirkenden magnetischen Fluß eine Hallspannung erzeugt. Diese Hallspannung wird zur Messung des Stromes herangezogen.

Aufgabe der vorliegenden Erfindung ist es, für einen derartigen Stromsensor einen Magnetkern anzugeben, der einerseits eine gute Empfindlichkeit für die magnetfeldabhängige Ausgangsgröße des Halbleiterelementes besitzt, bei dem außerdem bis zu sehr hohen Strömen die auf das magnetfeldabhängige Halbleiterelement einwirkende Induktion proportional zum Strom in dem elektrischen Leiter weitgehend unabhängig vom Leiterdurchmesser bleibt und bei dem eine nur geringe Abhängigkeit der auf das magnetfeldabhängige Halbleiterelement einwirkenden Induktion von Strömen in benachbarten elektrischen Leitern vorhanden ist.

Diese Aufgabe wird erfindungsgemäß dadurch gelöst, daß der Magnetkern aus einem mit Isolierstoff verpreßten weichmagnetischen Pulver besteht und einen im wesentlichen U-förmigen Kernteil besitzt, dessen offene Seite nach Einlegen des elektrischen Leiters durch ein Schlußstück abdeckbar ist, und daß das U-förmige Kernteil innen V-förmige Anschlagflächen aufweist, an denen der elektrische Leiter anliegt.

Aus den Landis & Gyr-Mitteilungen 20 (1973), Seite 11 ist es ferner bekannt, Dauermagnete aus AlNiCo dadurch herzustellen, daß eine AlNiCo-Legierung zu Pulver gemahlen, mit Kunstharz gemischt und hernach gepreßt und gegebenenfalls gesintert oder gehärtet wird. Im Gegensatz dazu wird bei der vorliegenden Anmeldung ein weichmagnetisches Pulver in Isolierstoff eingebettet.

Figur 1 zeigt einen Ringkern mit aus einem mit Isolierstoff verpreßten weichmagnetischen Pulver, der ähnlich wie in der US-PS 3 219 930 aufgebaut ist.

Figur 2 zeigt die Abhängigkeit der Ausgangsspannung eines Hallelementes $U_H$ in Abhängigkeit von einem das Magnetfeld verursachenden Strom $I_L$ für verschiedene Magnetkerne.

In Figur 3 ist ein Ausführungsbeispiel der Erfindung schematisch dargestellt.

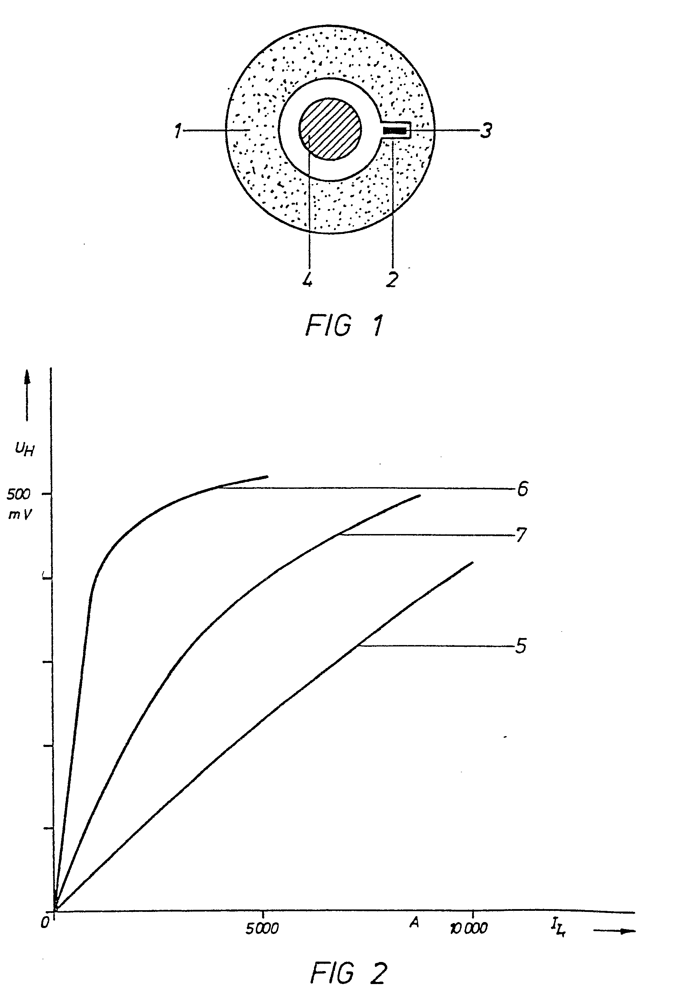

In Figur 1 ist ein kreisringförmiger Magnetkern 1 vorgesehen, der an einer Stelle seines Innenumfangs einen Einschnitt 2 aufweist. In diesem ist ein magnetfeldabhängiges Halbleiterelement 3 angeordnet, das beispielsweise ein Hallsensor sein kann, wie er in der erwähnten Zeitschrift « Feinwerktechnik » beschrieben ist. Durch den Magnetkern 1 ist ein elektrischer Leiter 4 hindurchgesteckt, dessen Strom durch das magnetfeldabhängige Halbleiterelement 3 möglichst linear nachgebildet werden soll. Der Magnetkern 1 besteht aus einem Gemisch von weichmagnetischem Eisenpulver und einem weiteren aus Isolierstoff bestehenden Pulver, das im wesentlichen Epoxydharz enthält und nicht magnetisch ist. Dieses Gemisch wird vorzugsweise in einem Gewichtsverhältnis von 95 : 5 miteinander vermischt in einer Presse bei einer Temperatur von etwa 200 °C zu dem in Figur 1 dargestellten Ring zusammengepreßt.

Hierdurch entsteht ein Material, das den magnetischen Fluß wesentlich besser leitet als Luft (relative Permeabilität $\mu_r \approx 4$) und wegen der Vielzahl von gleichmäßig verteilten Zwischenräumen zwischen den Pulverkörnern aus weichmagnetischem Material bis zu sehr hohen Strömen von ca. 10 000 Ampère in dem elektrischen Leiter 4 keine Sättigungserscheinungen erkennen läßt.

Figur 2 zeigt dazu ein Diagramm, bei dem die Ausgangsspannung eines als magnetfeldabhängiges Halbleiterelement verwendetes Hallelement $U_H$ in Abhängigkeit von dem Strom $I_L$ im elektrischen Leiter 4 dargestellt ist. Dabei gilt die Kurve 5 für einen Magnetkern, wie er in Figur 1 dargestellt ist. Die Kurve 6 erhält man, wenn man einen Kern mit gleicher geometrischer Form wie in Figur 1 verwendet und wenn dieser Kern aus weichmagnetischen Eisenblechen besteht. Hierbei ist anstelle des Einschnitts 2 in Figur 1 ein durchgehender Luftspalt vorgesehen worden, um bei kleineren Strömen überhaupt eine Ausgangsspannung zu erhalten. Die Kurve 7 ergibt sich, wenn man den Kern aus weichmagnetischem Material nur teilweise schließt und versucht, durch wesentliche Vergrößerung des wirksamen Luftspaltes bei dem der Kurve 6 zugehörigen Magnetkern die Sättigungserscheinungen zu vermindern.

Einen linearen Zusammenhang zwischen der Ausgangsgröße des Halbleiterelementes 3 und dem Strom im elektrischen Leiter 4 würde man auch erhalten, wenn man einen nichtmagnetischen Kern zur Halterung des

magnetfeldabhängigen Halbleiterelementes 3 verwenden würde. Allerdings ergäbe sich dann wegen der mit zunehmendem Abstand vom elektrischen Leiter 4 sich stark vermindernden Induktion eine größere Abhängigkeit der Ausgangsspannung von der Entfernung zum elektrischen Leiter 4 und außerdem würden auch die Magnetfelder benachbarter Leiter abhängig von ihrem Abstand zum Halbleiterelement 3 das Meßergebnis mit beeinflussen. Dies ist bei Verwendung ᵤₑₛ erfindungsgemäßen Magnetkerns nur in sehr viel geringerem Maße der Fall, da der magnetische Widerstand für den Fluß des im Magnetkern 1 angeordneten elektrischen Leiters 4 wesentlich geringer ist, als derjenige eines benachbarten Leiters.

Im Ausführungsbeispiel nach Figur 1 ist lediglich ein durch den Magnetkern hindurchgesteckter elektrischer Leiter 4 dargestellt und beschrieben worden. Die gleichen Ergebnisse gelten selbstverständlich auch für den Fall, daß zur Erfassung niedrigerer Ströme anstelle des durchgesteckten Leiters 4 eine elektrische Wicklung vorgesehen ist.

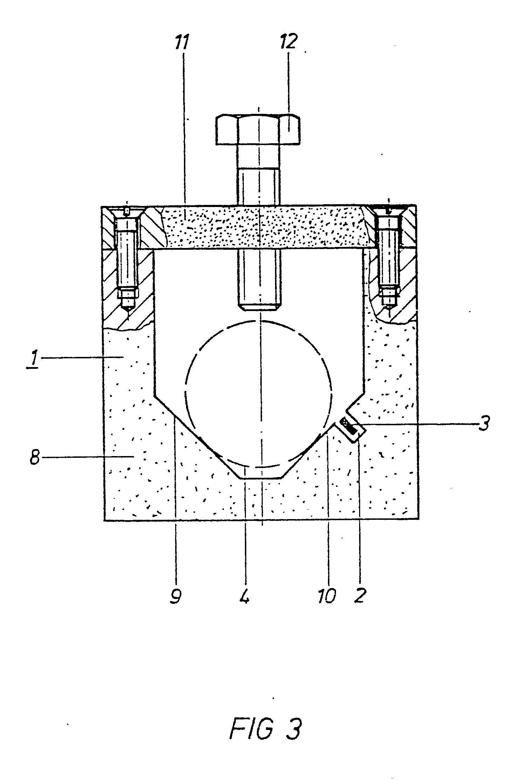

Ein besonders vorteilhaftes Ausführungsbeispiel der Erfindung ist in Figur 3 dargestellt. Diese Anordnung eignet sich für elektrische Leiter mit unterschiedlichen Durchmessern und weist eine noch geringere Empfindlichkeit gegenüber Störfeldern von benachbarten elektrischen Leitern auf. Hier besteht der Magnetkern aus einem Kernteil 8, das im wesentlichen U-förmig ausgebildet ist, das außen einen rechteckförmigen Querschnitt aufweist und innen am Fuße der U-Schenkel schräge Anschlagflächen 9 und 10 besitzt, an denen dann der im Kernteil 8 befindliche elektrische Leiter 4 anliegt. Die schrägen Anschlagflächen bilden miteinander eine V-Form, der Einschnitt 2 zur Aufnahme des magnetfeldabhängigen Halbleiterelementes 3 befindet sich symmetrisch zum U-förmigen Kernteil 8 in der Anschlagfläche 10.

Obgleich schon durch Verwendung eines Magnetkerns 1 aus einer gepreßten Pulvermischung die Abhängigkeit vom Abstand zwischen dem magnetfeldabhängigen Halbleiterelement und dem elektrischen Leiter 4 wesentlich vermindert ist, gegenüber einer Anordnung des Halbleiterelementes in Luft, wird durch die asymmetrische Anordnung des Einschnitts 2 zusätzlich erreicht, daß auch bei unterschiedlichen Querschnitten des elektrischen Leiters 4 sich dessen Abstand vom Einschnitt 2 nur minimal verändert. Hierdurch wird eine noch größere Unabhängigkeit der Ausgangsgrößen des Halbleiterelementes 3 vom Durchmesser des elektrischen Leiters 4 erreicht. Um den magnetischen Kreis des Magnetkerns 1 zu schließen und um den elektrischen Leiter 4 zu fixieren, ist die offene Seite des U-förmigen Kernteils durch ein ebenfalls aus einer gepreßten Pulvermischung bestehendes Verschlußstück 11 verschlossen. Das Verschlußstück 11 hält eine Anschlagschraube 12, durch die sich die Lage des elektrischen Leiters 4 fixieren läßt.

Wie aus Figur 3 zu ersehen ist, bedingt die äußere, rechteckförmige Form des U-förmigen Kernteils 8, daß im Bereich des Einschnitts 2 der Querschnitt des Magnetkerns 1 wesentlich vergrößert ist. Dies hat zur Folge, daß von den äußeren magnetischen Störfeldern nur ein besonders geringer Teil das Halbleiterelement 3 beeinflussen kann. Die Abhängigkeit des Meßergebnisses von Strömen in benachbarten Leitern ist dadurch weiter vermindert.

Beim dem erfindungsgemäßen Magnetkern ist es im Gegensatz zu einem weichmagnetischen Kern nicht mehr erforderlich, einen durchgehenden Luftspalt vorzusehen, da durch den mit dem Eisenpulver vermischten Isolierstoff sich ohnehin eine Vielzahl von « Luftspalten » in dem Material des Magnetkerns befinden. Hierdurch erreicht man weiterhin, daß das magnetfeldabhängige Halbleiterelement besonders beschützt angeordnet werden kann und Beschädigungen bei Montage und im Betrieb unwahrscheinlich sind.

## Patentansprüche

1. Magnetkern (1) aus weichmagnetischem Material für einen Stromsensor, der einen elektrischen Leiter (4) umgibt und in dem ein Einschnitt (2) mit einem darin angeordneten magnetfeldabhängigen Halbleiterelement (3) vorgesehen ist, dadurch gekennzeichnet, daß der Magnetkern (1) aus einem mit Isolierstoff verpreßten weichmagnetischen Pulver besteht und einen im wesentlichen U-förmigen Kernteil (8) besitzt, dessen offene Seite nach Einlegen des elektrischen Leiters (4) durch ein Schlußstück (11) abdeckbar ist, und daß das U-förmige Kernteil (8) innen V-förmige Anschlagflächen (9, 10) aufweist, an denen der elektrische Leiter (4) anliegt.

2. Magnetkern nach Anspruch 1, dadurch gekennzeichnet, daß der Einschnitt (2) zur Aufnahme des magnetfeldabhängigen Halbleiterelementes (3) asymmetrisch an einer Anschlagfläche (10) vorgesehen ist.

3. Magnetkern nach Anspruch 1, dadurch gekennzeichnet, daß dem weichmagnetischen Pulver Isolierstoff in einer derartigen Menge beigefügt ist, daß der Isolierstoffanteil des Materials über 4 Gewichts-% liegt.

## Claims

1. A magnetic core (1) made of soft magnetic material for a current sensor, which surrounds an electrical conductor (4) and in which there is provided a notch (2) having a magnetic field-dependent semiconductor element (3) arranged therein, characterised in that the magnetic core (1) consists of a soft magnetic powder, which is consolidated together with insulating material, and has an essentially U-shaped core member (8), the open side of which can be covered by an end piece (11) after the insertion of the electrical conductor (4) ; and that at the interior, the U-shaped core member (8) has V-shaped stop faces (9, 10), against which the electrical conductor (4) rests.

2. A magnetic core as claimed in Claim 1, characterised in that the notch (2) which serves to receive the magnetic field-dependent semiconductor element (3) is asymmetrically arranged at a stop face (10).

3. A magnetic core as claimed in Claim 1, characterised in that an insulating material is added to the soft magnetic powder in an amount such that the insulant proportion of the material lies above 4 % by weight.

**Revendications**

1. Noyau magnétique (1) en matériau magnétique doux pour un détecteur de courant qui entoure un conducteur électrique (4) et dans lequel il est prévu une encoche (2) avec un élément semi-conducteur (3) sensible au champ magnétique disposé à l'intérieur de cette encoche, noyau magnétique caractérisé en ce que ce noyau magnétique (1) est constitué d'une poudre en matériau magnétique mou pressée avec une matière isolante et qu'il comporte une partie de noyau (8) essentiellement en forme de U dont le côté ouvert après l'insertion du conducteur électrique (4) est susceptible d'être recouvert par une pièce de fermeture (11), tandis que la partie de noyau en forme de U (8) comporte des surfaces de butée internes en forme de V (9, 10) sur lesquelles s'applique le conducteur électrique (4).

2. Noyau magnétique selon la revendication 1, caractérisé en ce que l'encoche (2) destinée à recevoir l'élément semi-conducteur (3) sensible au champ magnétique, est prévue asymétrique et disposée sur une surface de butée (10).

3. Noyau magnétique selon la revendication 1, caractérisé en ce que de la matière isolante est ajoutée à la poudre de matériau magnétique doux en une quantité telle que la teneur en matière isolante du matériau se situe au-delà de 4 % en poids.

FIG 1

FIG 2

1

FIG 3